# EUROPÄISCHE PATENTSCHRIFT

(11) **EP 2 603 773 B1**
(45) Veröffentlichungstag und Bekanntmachung des Hinweises auf die Patenterteilung: **17.06.2020**
(21) Anmeldenummer: 11749780.0
(22) Anmeldetag: 04.08.2011
(51) Int. Cl.: G01D 5/14, G01B 7/012

(54) **SENSORANORDNUNG UND VERFAHREN ZUM BESTIMMEN EINER RÄUMLICHEN POSITION EINES ERSTEN TEILS RELATIV ZU EINEM ZWEITEN TEIL**
SENSOR ASSEMBLY AND METHOD FOR DETERMINING A SPATIAL POSITION OF A FIRST PART RELATIVE TO A SECOND PART
ENSEMBLE CAPTEUR ET PROCÉDÉ POUR DÉTERMINER UNE POSITION SPATIALE D'UNE PREMIÈRE PIÈCE PAR RAPPORT À UNE DEUXIÈME PIÈCE

(30) Priorität: 10.08.2010 DE 102010034482
(43) Veröffentlichungstag der Anmeldung: 19.06.2013
(73) Patentinhaber: Carl Zeiss Industrielle Messtechnik GmbH, 73447 Oberkochen (DE); Sensitec GmbH, 36633 Lahnau (DE)
(72) Erfinder: ENGEL, Thomas, 73432 Aalen (DE); LOREIT, Uwe, 35580 Wetzlar (DE)
(74) Vertreter: Witte, Weller & Partner Patentanwälte mbB
(86) Internationale Anmeldenummer: PCT/EP2011/063415
(87) Internationale Veröffentlichungsnummer: WO 2012/019958

(56) Entgegenhaltungen:
- WO-A1-01/51893
- DE-A1- 3 715 698
- DE-A1-102005 055 905

## Beschreibung

Die vorliegende Erfindung betrifft eine Sensoranordnung und ein Verfahren zum Bestimmen einer räumlichen Position eines ersten Teils relativ zu einem zweiten Teil.

Eine Sensoranordnung gemäß US 4,866,854 verwendet zwei Hallelemente als ersten und zweiten Magnetfeldsensor. Die beiden Hallelemente sind auf gegenüberliegenden Seiten eines Magneten angeordnet, so dass der Nordpol und der Südpol des Magneten zu jeweils einem Hallelement zeigen. Jedes Hallelement erzeugt ein Ausgangssignal, das für den senkrechten Abstand zwischen dem Hallelement und der ihm gegenüber liegenden Magnetseite repräsentativ ist. Bewegt sich der Magnet näher zu dem einen Hallelement hin, vergrößert sich der Abstand zu dem anderen Hallelement. Auf diese Weise wird eine Positionsänderung des ersten Teils relativ zu dem zweiten Teil entlang einer Messachse, die der Verbindungslinie zwischen den beiden Hallelementen entspricht, doppelt erfasst. Durch eine Differenzbildung der beiden Ausgangssignale wird ein gemeinsames Sensorsignal erzeugt, das für die aktuelle Position des Magneten zwischen den beiden Hallelementen repräsentativ ist. In einigen Ausführungsbeispielen schlägt US 4,866,854 vor, mehrere Magnete und mehrere Hallelement-Paare so anzuordnen, dass die aktuelle räumliche Position des ersten Teils relativ zu dem zweiten Teil entlang von mehreren Messachsen bestimmt werden kann. Dabei ist jeweils ein Magnet für jedes Hallelementpaar erforderlich.

Die Hallelemente der bekannten Sensoranordnung reagieren im Wesentlichen auf eine Änderung des Betrags der magnetischen Feldstärke. Durch die Differenzbildung der Ausgangssignale von jeweils zwei gegenüberliegenden Hallelementen erhält man ein gemeinsames Sensorsignal, das in etwa proportional zur Position des Magneten zwischen den beiden Hallelementen ist. Die bekannte Sensoranordnung soll eine gute Empfindlichkeit, Selektivität und Auflösung besitzen. Nachteilig ist, dass die bekannte Sensoranordnung für eine Positionsbestimmung in mehreren Messachsen eine Vielzahl von Magneten benötigt, die möglichst weit voneinander entfernt sein sollten, um eine gute Entkopplung zwischen den Sensorpaaren zu erreichen. Jedes Sensorpaar benötigt "seinen" Magneten. Die erforderlichen Abstände machen es schwierig, die bekannte Sensoranordnung für mehrere Messachsen kompakt zu realisieren. Des Weiteren erfordern die Montage und der Einbau der bekannten Sensoranordnung in ein Gerät, wie etwa den Tastkopf eines Koordinatenmessgerätes, viele einzelne Montageschritte.

Sensoranordnungen dieser Art werden insbesondere bei Koordinatenmessgeräten benötigt. Koordinatenmessgeräte besitzen üblicherweise einen sogenannten Tastkopf, der an einem Gestell befestigt ist. Mit Hilfe des Gestells kann der Tastkopf relativ zu einem Messobjekt bewegt werden. Der Tastkopf besitzt ein bewegliches Tastelement, typischerweise in Form eines Taststiftes. Der Tastkopf wird soweit an das Messobjekt herangefahren, bis das freie Ende des Taststiftes einen gewünschten Messpunkt berührt. Durch die Berührung wird der Taststift relativ zum Tastkopf ausgelenkt. Aus der Position des Tastkopfes relativ zum Messobjekt und aus der Position des Taststiftes relativ zum Tastkopf werden dann Raumkoordinaten bestimmt, die für den angetasteten Messpunkt repräsentativ sind. Durch Antasten einer Vielzahl von Messpunkten und Bestimmung der entsprechenden Raumkoordinaten können geometrische Abmessungen und/oder die Form des Messobjekts bestimmt werden.

DE 103 48 887 A1 offenbart einen solchen Tastkopf für ein Koordinatenmessgerät. Auch hier werden Paare von Hallelementen verwendet, um die Position des Taststiftes relativ zur Tastkopfbasis zu bestimmen. Wie bei der Anordnung aus US 4,866,854 wird für jede Messachse ein Hallelement-Paar benötigt. Auch hier sind die einzelnen Hallelement-Paare und die zugehörigen Magneten an verschiedenen Stellen des Tastkopfes möglichst entfernt voneinander angeordnet.

DE 10 2004 011 728 A1 offenbart einen weiteren Tastkopf für ein Koordinatenmessgerät mit Hallelementen und Magneten. Für jede Messachse ist ein Hallelement vorgesehen, das zwischen zwei gegenüberliegenden Magneten angeordnet ist. Zwei Messachsen der Sensoranordnung sind auf einer Trägerplatte kombiniert. Die dritte Raumrichtung muss mit einem Hallelement und einem zugehörigem Magnetpaar erfasst werden, die separat in dem Tastkopf montiert werden müssen.

Alternativ zu Hallelementen ist es möglich, sogenannte magnetoresistive Sensoren zu verwenden, um die Position eines Teils relativ zu einem Magnetfeld zu bestimmen.

DE 37 08 105 A1 offenbart einen solchen Tastkopf für ein Koordinatenmessgerät, wobei ein einziger Magnet am tastkopfseitigen Ende des Taststiftes angeordnet ist. Gegenüber von dem Magnet ist eine Detektorfläche angeordnet, auf der eine Vielzahl von magnetoresistiven Sensoren verteilt ist. Die bekannte Sensoranordnung ist recht kompakt. Die Messgenauigkeit ist jedoch begrenzt, da insbesondere das Erdmagnetfeld unbekannte Störungen hervorrufen kann.

Der Aufbau und das Funktionsprinzip von magnetoresistiven Sensoren sind aus verschiedenen Dokumenten bekannt, etwa aus DE 19521617 C1 oder aus zahlreichen Publikationen in Fachzeitschriften oder auf Fachtagungen. Die Sensoren basieren häufig auf dem sogenannten anisotropen magnetoresistiven Effekt (AMR-Effekt) oder auf dem gigantischen magnetoresistiven Effekt (GMR-Effekt). Der AMR-Effekt verändert den elektrischen Widerstand eines von Strom durchflossenen, ferromagnetischen Materials in Abhängigkeit von dem Winkel zwischen Stromdichtevektor und Magnetfeldvektor. Der GMR-Effekt ist ein quantenmechanischer Effekt, der ebenfalls eine Änderung des elektrischen Widerstandes einer ferromagnetischen Struktur bewirkt. AMR- und GMR-Sensoren haben die früher verwendeten sogenannten Feldplatten verdrängt. Feldplatten sind magnetisch veränderbare Widerstände, bei denen die Widerstandsänderung aus einer Änderung der Weglänge der Elektronen im Magnetfeld aufgrund der Lorentzkraft basiert.

DE 10 2005 055 905 A1 beschreibt eine Längenmessanordnung mit einem magnetischen Encoder, der relativ zu einer Sensoraufnahme entlang einer Richtung beweglich ist. Der magnetische Encoder besitzt mehrere unterschiedliche magnetische Segmente und die Sensoraufnahme besitzt zwei mit Abstand voneinander angeordnete Magnetfeldsensoren, zwischen denen sich der Encoder bewegen kann. Der Feldlinienverlauf, den der jeweilige Magnetfeldsensor misst, muss über den gesamten Messbereich eine Änderung bezüglich der Messrichtung aufweisen. Die Signale der beiden Magnetfeldsensoren werden zweckmäßig im Verhältnis zueinander betrachtet.

Eine ähnliche Sensoranordnung ist aus WO 01/51893 A1 bekannt. Hier läuft ein stabförmiger Encoder mit wechselnden magnetischen Segmenten zwischen zwei Magnetfeldsensoren, die insbesondere den anisotropen magnetoresistiven Effekt nutzen.

DE 37 15 698 A1 offenbart einen Tastkopf mit drei Feldplatten, die auf einem äußeren Kreisring angeordnet sind, der konzentrisch zu einem inneren Kreisring mit magnetischen Gegenpolen liegt. Diese Sensoranordnung erscheint recht kompakt. Allerdings dürfte die Messgenauigkeit aufgrund der verwendeten Sensoren und aufgrund von Einflüssen des Erdmagnetfeldes sehr begrenzt sein.

Vor diesem Hintergrund ist es eine Aufgabe der vorliegenden Erfindung, eine Sensoranordnung der eingangs genannten Art anzugeben, die auch bei äußeren Störungen, wie etwa Variationen des Erdmagnetfeldes, eine sehr genaue Positionsbestimmung ermöglicht und die zudem sehr kompakt realisiert werden kann, insbesondere als 3D-Sensoranordnung, das heißt in Form einer Sensoranordnung, die in der Lage ist, die räumliche Position entlang von drei orthogonalen Messachsen zu bestimmen.

Diese Aufgabe wird gemäß einem ersten Aspekt der Erfindung durch eine Sensoranordnung nach Anspruch 1 gelöst, mit zumindest vier Magnetfeldsensoren, die ein erstes Paar und ein zweites Paar mit jeweils einem ersten und einem zweiten Magnetfeldsensor bilden, wobei jedes Paar ein gemeinsames Sensorsignal in Bezug auf eine von zumindest zwei zueinander orthogonalen Messachsen erzeugt.

Die Aufgabe wird gemäß einem weiteren Aspekt durch ein Verfahren nach Anspruch 12 gelöst, wobei zumindest vier Magnetfeldsensoren, die ein erstes und ein zweites Paar mit jeweils einem ersten und einem zweiten Magnetfeldsensor bilden, verwendet werden, wobei jedes Paar ein gemeinsames Sensorsignal in Bezug auf eine von zumindest zwei zueinander orthogonalen Messachsen erzeugt.

Besonders bevorzugt werden die Sensoranordnung und das Verfahren in einem Tastkopf für ein Koordinatenmessgerät verwendet, um die Auslenkung des Tastelements (Taststiftes) relativ zu der Tastkopfbasis zu bestimmen.

Die neue Sensoranordnung besitzt zumindest vier Magnetfeldsensoren, die ein erstes Paar und ein zweites Paar mit jeweils einem ersten und einem zweiten Magnetfeldsensor bilden, wobei jedes Paar ein gemeinsames Sensorsignal in Bezug auf eine von zumindest zwei zueinander orthogonalen Messachsen erzeugt. Vorzugsweise beinhaltet die Sensoranordnung zumindest sechs Magnetfeldsensoren, die zumindest drei Paare bilden, wobei jedes Paar für eine von drei orthogonalen Messachsen ein gemeinsames Sensorsignal liefert. Damit wird eine kompakte 2D- oder sogar 3D-Sensoranordnung bereitgestellt, die Positionsinformationen für mehrere Raumrichtungen liefert. Sie eignet sich dafür besonders gut, um die Auslenkungen eines Taststiftes relativ zu einer Tastkopfbasis zu bestimmen.

Im Gegensatz zu der Sensoranordnung aus der eingangs genannten US 4,866,854 verläuft die jeweilige Messachse nicht auf der Verbindungslinie zwischen den beiden jeweiligen Magnetfeldsensoren, sondern quer dazu. In bevorzugten Ausgestaltungen verläuft die Messachse orthogonal zu dem Abstandsvektor zwischen den beiden jeweiligen Magnetfeldsensoren. Dementsprechend bewegt sich der Magnet quer und vorzugsweise orthogonal zu der Verbindungslinie zwischen den beiden jeweiligen Magnetfeldsensoren. Die Magnetfeldsensoren erfassen jeweils die aktuelle Magnetfeldrichtung, d.h. die Vektorrichtung der magnetischen Feldlinien am Ort des Sensors. In den bevorzugten Ausgestaltungen sind die Ausgangssignale der Magnetfeldsensoren weitgehend unabhängig vom Betrag der magnetischen Feldstärke, das heißt die Magnetfeldsensoren werten praktisch nur die Richtung des Magnetfeldes relativ zu den Sensoren aus. Auf den Betrag der magnetischen Feldstärke, das heißt die Stärke des Magnetfeldes am Ort der Sensoren, kommt es folglich nicht an, solange die magnetische Feldstärke überhaupt hoch genug ist, um ein Ausgangssignal mit den Sensoren zu erzeugen.

In bevorzugten Ausführungsbeispielen sind die Magnetfeldsensoren magnetoresistive Sensoren, die auf dem AMR-Effekt basieren. In anderen Ausführungsbeispielen können die Magnetfeldsensoren GMR-Sensoren sein. Darüber hinaus können die Magnetfeldsensoren prinzipiell auch andere Sensoren sein, bei denen die Ausgangssignale in erster Linie von der Magnetfeldrichtung und nicht oder nur unwesentlich von der Magnetfeldstärke abhängen.

Die neue Sensoranordnung verwendet paarweise magnetfeldrichturigsdetektierende Sensoren in einem gemeinsamen Magnetfeld, wobei die beiden jeweiligen Sensoren der Doppelanordnung auf gegenüberliegenden Seiten des Magneten liegen. Dies hat zur Folge, dass sich Richtungsänderungen des gemeinsamen Magnetfeldes aufgrund einer Relativbewegung der beiden Teile gegenläufig verhalten. Daher lassen sich äußere Störungen, beispielsweise in Folge des Erdmagnetfeldes, leicht eliminieren. Des weiteren sind die Ausgangssignale der Sensoren recht unempfindlich gegenüber Temperaturänderungen, da die Magnetfeldrichtung wesentlich weniger von der Umgebungstemperatur abhängt als beispielsweise die Magnetfeldstärke eines Magneten. Zudem kann der Verlauf der Magnetfeldlinien durch die geometrischen Abmessungen und die geometrische Anordnung des zumindest eines Magneten recht genau bestimmt und optimiert werden. Es ist vorteilhaft, wenn die magnetischen Feldlinien im Bereich der Sensoren eine relativ starke Krümmung aufweisen, weil die Sensoren dann sehr sensibel auf eine Verschiebung des Magnetfeldes reagieren. Infolgedessen kann die neue Sensoranordnung recht einfach für eine hohe Messgenauigkeit optimiert werden und die hohe Messgenauigkeit lässt sich durch Reproduktion der geometrischen Abmessungen sehr gut in einer Serienproduktion gewährleisten. Dadurch kann die neue Sensoranordnung sehr kostengünstig realisiert werden.

Wie weiter unten anhand bevorzugter Ausführungsbeispiele erläutert ist, kann die neue Sensoranordnung besonders vorteilhaft als 3D-Sensoranordnung realisiert werden, wobei eine einzige integrierte Sensorbaugruppe in der Lage ist, alle sechs Freiheitsgrade der beiden relativ zueinander bewegten Teile zu bestimmen. Die oben genannte Aufgabe ist daher vollständig gelöst.

In einer bevorzugten Ausgestaltung der Erfindung besitzt die Sensoranordnung einen Addierer, der die Ausgangssignale des ersten und zweiten Magnetfeldsensors addiert, um das gemeinsame Sensorsignal zu bestimmen. Vorzugsweise ist der Addierer ferner in der Lage, einen Mittelwert der beiden Ausgangssignale des ersten und zweiten Magnetfeldsensors zu bilden.

Dementsprechend repräsentiert das gemeinsame Sensorsignal in bevorzugten Ausgestaltungen der Erfindung den Mittelwert der beiden Ausgangssignale unter Berücksichtigung der gegenläufigen Magnetfeldrichtungen. In einigen bevorzugten Ausführungsbeispielen liefern die Sensoren jeweils zumindest ein Ausgangssignal, das sich sinusförmig oder kosinusförmig ändert, wenn sich die Position des ersten Teils relativ zum zweiten Teil verändert. Da die Magnetfeldlinien des gemeinsamen Magnetfeldes an den beiden entfernten Sensoren gegenläufig sind, bildet der Addierer ein Sensorsignal, das bei ungestörtem, ideal symmetrischen Magnetfeld an den beiden Sensoren Null ist. Abweichungen von Null sind entweder auf eine Auslenkung des ersten Teils relativ zum zweiten Teil zurückzuführen, oder auf eine Störung der Symmetrie des Magnetfeldes zwischen den beiden Sensoren. Bestimmt man vor einer Messung die Ruheposition des ersten Teils, ggf. mit Hilfe einer Kalibrierung, lassen sich Störungen mit Hilfe des Summensignals sehr leicht erkennen und bei der Positionsbestimmung eliminieren.

In einigen Ausführungsbeispielen ist der Addierer mit Hilfe einer direkten hardwaremäßigen Parallelschaltung der Ausgangssignale realisiert. In anderen Ausführungsbeispielen beinhaltet die Sensoranordnung einen programmierbaren Schaltkreis, wie etwa einen Mikrokontroller, Mikroprozessor, ASIC oder FPGA, die die Addition der Ausgangssignale und die bevorzugte Mittelwertbildung bewirken.

In einer weiteren Ausgestaltung der Erfindung beinhaltet die Sensoranordnung einen Subtrahierer, der eine Differenz zwischen den Ausgangssignalen des ersten und zweiten Magnetfeldsensors bildet, um das gemeinsame Sensorsignal zu bestimmen. Besonders bevorzugt ist es, wenn die Sensoranordnung sowohl einen Addierer als auch einen Subtrahierer beinhaltet, um ein Summensignal und ein Differenzsignal aus den beiden Ausgangssignalen der Magnetfeldsensoren zu bestimmen.

Mit Hilfe der Differenz zwischen den beiden Ausgangssignalen lässt sich eine Verdrehung des Magnetfeldes relativ zu den beiden Magnetfeldsensoren und folglich eine Verdrehung des ersten Teils relativ zu dem zweiten Teil bestimmen. Daher ermöglicht diese Ausgestaltung die Bestimmung eines gemeinsamen Sensorsignals, das für einen weiteren Freiheitsgrad repräsentativ ist. In bevorzugten Ausführungsbeispielen sind die beiden Ausgangssignale dem Addierer und dem Subtrahierer parallel zugeführt, was eine sehr schnelle Bestimmung von zwei gemeinsamen Sensorsignalen ermöglicht, die für zwei verschiedene Freiheitsgrade der Relativbewegung repräsentativ sind.

In einem bevorzugten Ausführungsbeispiel beinhaltet die Sensoranordnung drei Sensorpaare mit jeweils zwei Magnetfeldsensoren, wobei jedes Sensorpaar ein Summensignal und ein Differenzsignal in Bezug auf eine andere Messachse liefert. Mit einer solchen Sensoranordnung können alle sechs Freiheitsgrade und damit die sogenannte Pose des ersten Teils relativ zu dem zweiten Teil einfach und schnell bestimmt werden.

In einer weiteren Ausgestaltung besitzen die Magnetfeldsensoren jeweils einen elektrischen Widerstand, der sich in Abhängigkeit von der Magnetfeldrichtung verändert.

In dieser Ausgestaltung sind die Magnetfeldsensoren magnetoresistive Sensoren, insbesondere AMR-Sensoren. Des weiteren ist es bevorzugt, wenn die Sensoren eine gemeinsame Messebene aufspannen, in der die für die Auswertung maßgeblichen Magnetfeldlinien laufen.

Diese Ausgestaltungen ermöglichen eine sehr flache und dementsprechend kompakte Realisierung der neuen Sensoranordnung.

In einer weiteren Ausgestaltung erzeugen der erste und der zweite Magnetfeldsensor jeweils zwei verschiedene analoge Ausgangssignale mit jeweils einem Momentanwert, der sinus- oder cosinusförmig von der Magnetfeldrichtung am Ort des jeweiligen Magnetfeldsensors abhängt.

Geeignete Magnetfeldsensoren dieser Ausgestaltung sind insbesondere magnetoresistive Sensoren, die intern jeweils zwei um 45° zueinander verdrehte Widerstandsmessbrücken beinhalten. Eine erste dieser Widerstandsmessbrücken liefert ein erstes Analogsignal, das sinusförmig von der Richtung des Magnetfeldes am Ort des Sensor abhängt. Eine zweite dieser Widerstandsmessbrücken liefert ein zweites Analogsignal, das aufgrund der 45°-Verdrehung kosinusförmig von der Richtung des Magnetfeldes am Ort des Sensor abhängt. Zusammen ermöglichen die beiden Analogsignale eine sehr genaue Bestimmung der Magnetfeldrichtung am Ort des Sensors. Die Verwendung solcher Magnetfeldsensoren ermöglicht eine sehr schnelle Signalverarbeitung, indem man die sinusförmigen (bzw. kosinusförmigen) Analogsignale des ersten Sensors um 180° verdreht mit den sinusförmigen (bzw. kosinusförmigen) Analogsignalen des zweiten Sensors elektrisch verbindet und somit die Analogsignale in einer Parallelschaltung zusammenführt. Durch das elektrische Verbinden der Sinus- bzw. Kosinussignale der beiden Sensoren erhält man sehr einfach und schnell zwei gemeinsame Ausgangssignale, die für die Magnetfeldrichtung repräsentativ sind. Dabei werden Störungen des Magnetfeldes durch die Signalverarbeitung sehr wirksam kompensiert.

In einer weiteren Ausgestaltung beinhaltet die Sensoranordnung einen Bauteilträger, an dem die Magnetfeldsensoren der Paare gemeinsam angeordnet sind. In bevorzugten Ausführungsbeispielen ist der Bauteilträger weitgehend scheibenförmig. Insbesondere ist der Bauteilträger eine Schaltungsplatine, an der die Magnetfeldsensoren dauerhaft befestigt sind, etwa aufgelötet. Vorteilhafterweise sind auf der Schaltungsplatine weitere Schaltungselemente angeordnet, insbesondere der Addierer und/oder Subtrahierer, oder ein Temperatursensor, der ein für die Betriebstemperatur der Schaltungsplatine repräsentatives Temperatursignal liefert. Des Weiteren ist es bevorzugt, wenn der Bauteilträger aus einem temperaturstabilen Material besteht, etwa aus einem keramischen Material, und/oder einen bekannten Temperaturausdehnungskoeffizienten besitzt.

In dieser Ausgestaltung Ist die Sensoranordnung eine integrierte Sensoranordnung mit Sensorpaaren für mehrere Messachsen. Die Ausgestaltung ermöglicht eine sehr kompakte Realisierung und eine kostengünstige Montage in einem Tastkopf. Die Integration mehrere Sensorpaare auf einem Bauteilträger gewährleistet außerdem eine gleichbleibend hohe Messgenauigkeit über eine Vielzahl von baugleichen Sensoranordnungen hinweg. Die Integration eines Temperatursensors auf dem Bauteilträger ermöglicht darüber hinaus eine vorteilhafte Temperaturkompensation und infolgedessen eine noch höhere Messgenauigkeit.

In einer weiteren Ausgestaltung weist der Bauteilträger eine zentrale Ausnehmung auf, in der der zumindest eine Magnet angeordnet ist.

In dieser Ausgestaltung verwendet die Sensoranordnung ein gemeinsames Magnetfeld für die Magnetfeldsensoren der integrierten Paare. Dies bedeutet, dass ein einziges Magnetfeld Positionsinformationen für zumindest zwei orthogonale Messachsen liefert. In bevorzugten Ausführungsbeispielen verwendet die Sensoranordnung ein einziges gemeinsames Magnetfeld für alle Messachsen und damit für alle Sensorpaare.

Die Ausgestaltung trägt zu einer besonders kompakten Bauweise bei. Darüber hinaus ermöglicht diese Ausgestaltung eine gleichmäßig hohe Messgenauigkeit für alle Messachsen, da für alle Messachsen eine gemeinsame Referenz ausgewertet wird.

In einer weiteren Ausgestaltung beinhaltet die Sensoranordnung eine Vielzahl von Magneten, die in der Ausnehmung angeordnet sind und ein gemeinsames Magnetfeld erzeugen. Vorzugsweise ist das gemeinsame Magnetfeld rotationssymmetrisch in Bezug auf zumindest zwei Messachsen, d.h. das gemeinsame Magnetfeld sieht für zumindest zwei orthogonale Messachsen gleich aus. In einem besonders bevorzugten Ausfiihrungsbeispiel beinhaltet die Sensoranordnung vier Magnete, die in Form eines Kreuzes angeordnet sind.

Diese Ausgestaltung ermöglicht eine sehr kompakte Bauform mit einem gemeinsamen Magnetfeld, das eine hohe Messgenauigkeit für alle Messachsen bietet. Die Rotationssymmetrie des Magnetfeldes ist besonders vorteilhaft für eine Anwendung in dem Tastkopf eines Koordinatenmessgerätes, da sie weitgehend identische Messgenauigkeiten in zwei orthogonalen Messachsen liefert. Vorteilhaft werden diese beiden Achsen quer zur Erdanziehungskraft angeordnet, das heißt sie bilden eine Messebene, die bei Koordinatenmessgeräten in Portal- oder Brückenbauweise üblicherweise als x-y-Messebene bezeichnet wird.

In einer weiteren Ausgestaltung weist der Bauteilträger eine Oberseite und eine Unterseite auf, an denen jeweils erste und zweite Magnetfeldsensoren angeordnet sind. Vorzugsweise sind die Oberseite und die Unterseite weitgehend parallel zueinander. In bevorzugten Ausführungsbeispielen ist der Bauteilträger eine doppelseitig bestückte Schaltungsplatine.

Diese Ausgestaltung ermöglicht eine kompakte Sensorbaugruppe mit Magnetfeldsensoren, die in drei orthogonalen Raumrichtungen voneinander beabstandet sind. In einem Ausfuhrungsbeispiel sind die Oberseite und die Unterseite des Bauteilträgers spiegelbildlich zueinander mit Magnetfeldsensoren bestückt, so dass zumindest zwei Sensorpaare gebildet sind, von denen eines auf der Oberseite und eines auf der Unterseite des Bauteilträgers angeordnet ist. Die Sensorpaare liegen folglich in zwei verschiedenen Messebenen, was in bevorzugten Ausführungsbeispielen vorteilhaft dazu verwendet wird, eine Neigung des Bauteilträgers um eine zu den Messebenen parallele Achse zu detektieren. In anderen Ausführungsbeispielen können jeweils ein Magnetfeldsensor auf der Oberseite und ein Magnetfeldsensor auf der Unterseite ein Sensorpaar bilden. Die Ausgestaltung ermöglicht ferner, ausgewählte Magnetfeldsensoren für mehr als ein Sensorpaar zu verwenden. Insbesondere kann das Ausgangssignal eines Magnetfeldsensors einmal mit dem Ausgangssignal eines anderen Magnetfeldsensors auf derselben Seite und ein zweites Mal mit dem Ausgangssignal eines Magnetfeldsensors auf der gegenüberliegenden Seite kombiniert werden, so dass Sensorsignale für mehrere Messrichtungen mit einer geringen Anzahl von Magnetfeldsensoren zur Verfügung stehen. In einigen vorteilhaften Ausführungsbeispielen beinhaltet die Sensoranordnung einen programmierbaren Schaltkreis, der dazu eingerichtet ist, die digitale oder digitalisierte Ausgangssignale der Sensoren in verschiedenen definierten Kombinationen miteinander in Beziehung zu setzen. In einem bevorzugten Fall realisiert der programmierbare Schaltkreis damit eine Überwachungs- und Diagnosefunktion, die es ermöglicht, eine Messunsicherheit ausgewählter Sensorpaare und/oder deren bestimmungsgemäße Funktion mit Hilfe eines Kreuzvergleichs zu überprüfen. Sehr vorteilhaft ist es ferner, wenn die Ausgangssignale der Magnetfeldsensoren zu mehreren verschiedenen Sensorpaaren kombiniert werden, da man auf diese Weise sehr effizient Plausibilitätsvergleiche durchführen kann.

In einer weiteren Ausgestaltung beinhaltet die Sensoranordnung eine Temperaturkorrekturstufe, die dazu ausgebildet ist, eine thermisch bedingte Positionsänderung von dem ersten Teil relativ zu dem zweiten Teil anhand der Ausgangssignale zu bestimmen.

In dieser Ausgestaltung erfolgt eine Temperaturkompensation vorteilhafterweise allein anhand der Ausgangssignale der Magnetfeldsensoren. In einem Ausführungsbeispiel sind die Ausgangssignale der Magnetfeldsensoren bei einer Referenztemperatur in einem Speicher der Sensoranordnung und/oder einem Speicher eines Koordinatenmessgerätes gespeichert. Vor einer Messung werden die Ausgangssignale der Magnetfeldsensoren zunächst ohne Auslenkung/Positionsveränderung zwischen dem ersten und dem zweiten Teil bestimmt. Eine Abweichung der Ausgangssignale gegenüber den Ausgangssignalen bei der Referenztemperatur ermöglicht die bevorzugte Temperaturkomponsensation ohne einen speziellen Temperatursensor oder in Ergänzung dazu.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind.

Ausführungsbeispiele der Erfindung sind in der Zeichnung dargestellt und werden in der nachfolgenden Beschreibung näher erläutert. Es zeigen:
- Figur 1: ein Koordinatenmessgerät mit einem Tastkopf, in dem ein Ausführungsbeispiel der Sensoranordnung verwendet ist,
- Figur 2: den mechanischen Aufbau des Tastkopfes aus Figur 1 in einer teilweise geschnittenen Darstellung,
- Figur 3: eine schematische Darstellung einer Sensoranordnung, die für sich nicht unter die Ansprüche fällt,
- Figur 4: eine schematische Darstellung einer weiteren Sensoranordnung, die für sich nicht unter die Ansprüche fällt,
- Figur 5: eine weitere Sensoranordnung, die für sich nicht unter die Ansprüche fällt,
- Figur 6: ein Ausführungsbeispiel der neuen Sensoranordnung mit zwei Sensorpaaren für zwei orthogonale Messachsen,
- Figur 7: den mechanischen Aufbau der Sensoranordnung in einem bevorzugten Ausführungsbeispiel,
- Figur 8: eine schematische Darstellung des gemeinsamen Magnetfeldes der Sensoranordnung aus Figur 7, und
- Figur 9: ein gemeinsames Magnetfeld der Sensoranordnung aus Figur 7 gemäß einem alternativen Ausführungsbeispiel.

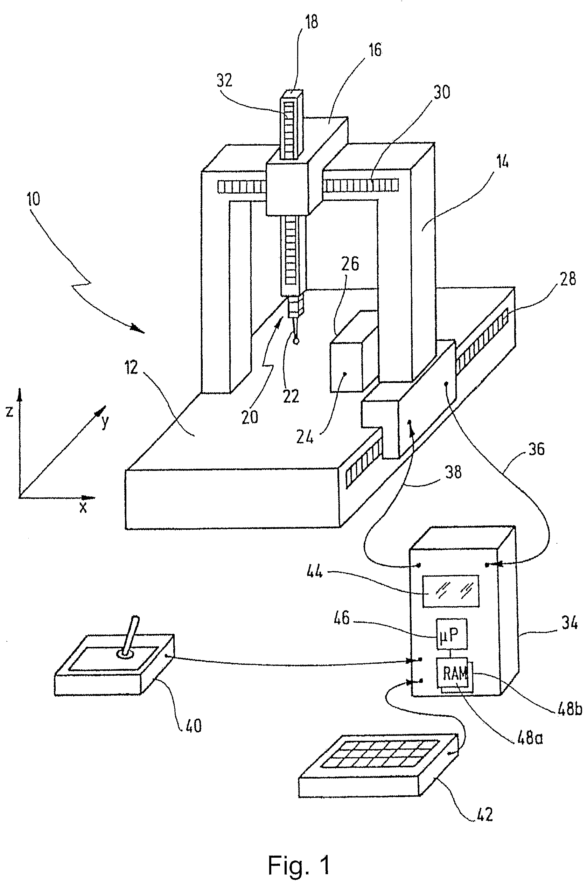

In Fig. 1 ist ein Koordinatenmessgerät, in dem die neue Sensoranordnung verwendet ist, in seiner Gesamtheit mit der Bezugsziffer 10 bezeichnet. Wenngleich die Verwendung der neuen Sensoranordnung in der Koordinatenmesstechnik aus heutiger Sicht bevorzugt ist, ist die Erfindung darauf nicht beschränkt. Vielmehr kann die Sensoranordnung auch in anderen Fällen vorteilhaft eingesetzt werden, in denen die Position eines ersten Teils relativ zu einem zweiten Teil mit hoher Genauigkeit bestimmt werden soll.

Das Koordinatenmessgerät 10 besitzt eine Basis 12, auf der hier ein Portal 14 angeordnet ist. Das Portal 14 kann relativ zu der Basis 12 in einer ersten Raumrichtung bewegt werden. Typischerweise wird diese Raumrichtung als y-Achse bezeichnet. Am oberen Querträger des Portals 14 ist ein Schlitten 16 angeordnet, der relativ zu dem Portal 14 in einer zweiten Raumrichtung verfahren werden kann. Die Bewegungsachse des Schlittens 16 wird üblicherweise als x-Achse bezeichnet. Am Schlitten 16 ist eine Pinole 18 angeordnet, die relativ zu dem Schlitten in einer dritten Raumrichtung verfahren werden kann. Diese dritte Raumrichtung wird üblicherweise als z-Achse bezeichnet. Am unteren freien Ende der Pinole 18 ist ein Tastkopf 20 mit einem Taststift 22 angeordnet. Der Taststift dient dazu, einen Messpunkt 24 an einem Messobjekt 26 anzutasten, während das Messobjekt 26 auf der Basis 12 angeordnet ist. Anschließend kann aus der Position des Tastkopfes 20 relativ zu den Koordinatenachsen x, y, z eine Raumposition des angetasteten Messpunktes 24 bestimmt werden. Wenn man die Raumkoordinaten zu einer Vielzahl von Messpunkten 24 an dem Messobjekt 26 bestimmt, kann man geometrische Abmessungen und/oder die Raumform des Messobjekts 26 bestimmen.

Das Koordinatenmessgerät 10 ist hier in Portalbauweise mit einem beweglichen Portal dargestellt. Es gibt andere Bauweisen für Koordinatenmessgeräte, etwa Horizontalarmmessgeräte oder Messgeräte, bei denen die Basis 12 mit dem Messobjekt 26 bewegt wird. Es versteht sich, dass die neue Sensoranordnung auch bei solchen Koordinatenmessgeräten vorteilhaft verwendet werden kann.

Mit den Bezugsziffern 28, 30, 32 sind Positionsgeber für die Bewegungsachsen des Koordinatenmessgerätes bezeichnet, die beispielsweise einen Inkrementalgeber oder Linearmaßstab beinhalten können. Mit Hilfe der Positionsgeber 28, 30, 32 bestimmt eine Auswerte- und Steuereinheit 34 die jeweils aktuelle Raumposition des Tastkopfes 20 innerhalb des Messvolumens. Des Weiteren steuert die Auswerte- und Steuereinheit 34 hier die Bewegungen des Portals 14, des Schlittens 16 und der Pinole 18. Dementsprechend ist die Auswerte- und Steuereinheit 34 über Leitungen 36, 38 mit dem Positionsgebern 28, 30, 32 und den Antrieben (hier nicht dargestellt) des Koordinatenmessgerätes 10 verbunden.

Mit der Bezugsziffer 40 ist ein Bedienteil bezeichnet, mit dem ein Bediener des Koordinatenmessgerätes 10 die Position des Tastkopfes 20 verändern kann. In den bevorzugten Ausführungsbeispielen besitzt die Auswerte- und Steuereinheit 34 außerdem eine Tastatur 42 und eine Anzeige 44 sowie einen Prozessor 46 und Speicher 48. Der Speicher 48a kann beispielsweise ein Arbeitsspeicher zum flüchtigen Abspeichern von Messwerten sein, während der Speicher 48b ein Steuer- und Messprogramm für das Messobjekt 26 enthält.

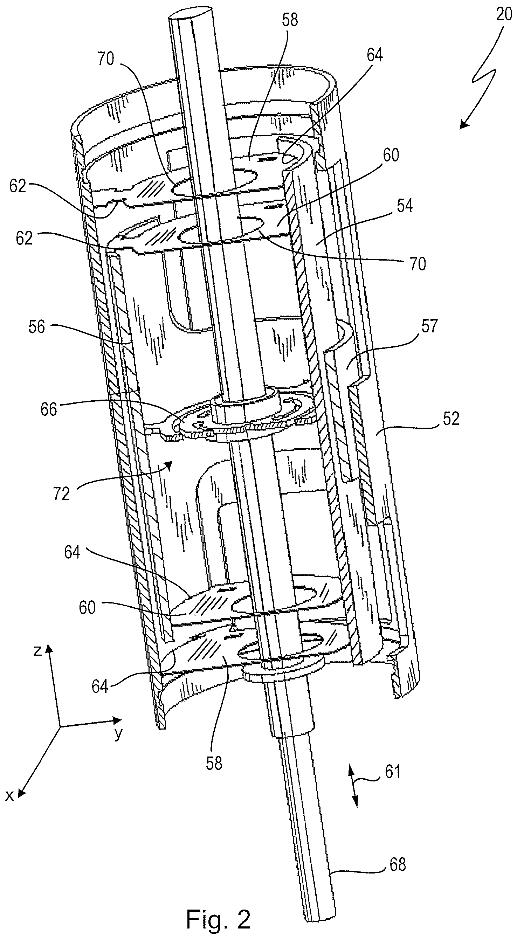

Fig. 2 zeigt den mechanischen Aufbau eines Tastkopfes 20 gemäß einem bevorzugten Ausführungsbeispiel. Der Tastkopf 20 besitzt eine zylindrische Tastkopfbasis 52, die einen feststehenden Teil bildet, gegenüber dem sich der Taststift 22 bewegen kann. Es versteht sich, dass die Tastkopfbasis 52 selbst mit Hilfe der Antriebe des Koordinatenmessgerätes 10 in dem Messvolumen bewegt werden kann.

Der Tastkopf 20 besitzt hier zwei Zylinderschalen 54, 56, die weitgehend konzentrisch innerhalb der Tastkopfbasis 52 angeordnet sind. Die Zylinderschalen 54, 56 weisen mit ihren jeweiligen Zylinderschaleninnenseiten aufeinander zu. Die Zylinderschale 56 besitzt einen Verlängerungsarm 57, der die Zylinderschale 54 von außen umgreift.

Die erste Zylinderschale 54 ist über zwei Blattfedern 58 an der Innenseite der Tastkopfbasis 52 befestigt. Aufgrund der Blattfedern 58 bilden die Tastkopfbasis 52 und die Zylinderschale 54 ein Federparallelogramm, das eine Bewegung der Zylinderschale 54 relativ zu der Tastkopfbasis 52 in einer Richtung ermöglicht, die in Fig. 2 mit dem Pfeil 61 angedeutet ist. In einigen Ausführungsbeispielen ist diese Bewegungsrichtung 61 parallel zur z-Achse des Koordinatenmessgerätes 10. Es gibt jedoch auch Fälle, in denen der Tastkopf 20 aus der in Fig. 1 dargestellten Orientierung verschwenkt werden kann, so dass die Bewegungsrichtung 61 dann nicht parallel zur z-Achse des Koordinatenmessgerätes 10 ist.

Die zweite Zylinderschale 56 ist über zwei weitere Blattfedern 60 an der ersten Zylinderschale 54 befestigt und bildet mit der Zylinderschale 54 ein zweites Federparallelogramm. Zusammen bilden die beiden Zylinderschalen 54, 56 mit den Blattfedern 58, 60 ein Doppelfederparallelegramm, das eine geradlinige Bewegung in Richtung des Pfeils 61 ermöglicht.

In dem bevorzugten Ausführungsbeispiel besitzen die Blattfedern 58, 60 jeweils eine Dreipunktverbindung mit den Zylinderschalen und der Tastkopfbasis. Dies bedeutet, sie sind über einen weitgehend singulären Verbindungspunkt 62 mit der einen Zylinderschale und über eine eher linienartige oder mehrere Verbindungspunkte beinhaltende Verbindung 64 mit der anderen Zylinderschale verbunden. Diese Dreipunktelagerung reduziert innere Spannungen.

Die beiden Zylinderschalen 54, 56 halten eine Membranfeder 66, die weitgehend konzentrisch innerhalb der Tastkopfbasis 52 angeordnet ist. An der Membranfeder 66 ist ein Stab 68 befestigt, der sich durch Ausnehmungen 70 in den Blattfedern 58, 60 erstreckt. Der Stab 68 ist eine Verlängerung und/oder Halterung für den Taststift 22. Zusammen bilden die Zylinderschalen 54, 56, Blattfedern 58, 60 und die Membranfeder 66 eine Lagerung 72 für den Taststift 22 mit Freiheitsgraden in den drei orthogonalen Raumrichtungen x, y, z. Es ist Aufgabe der neuen SensoranOrdnung, die jeweilige Position des Taststiftes 22 relativ zur Tastkopfbasis 52 zu erfassen.

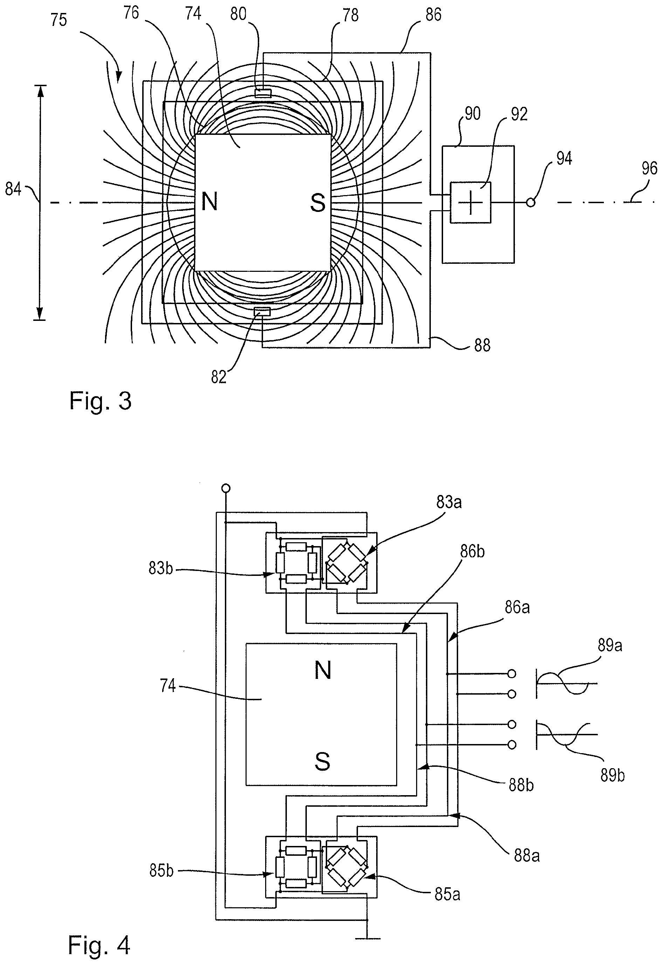

Fig. 3 zeigt eine vereinfachte, schematische Darstellung einer Sensoranordnung, die als solche nicht unter die Ansprüche fällt. In Fig. 3 bezeichnet die Bezugsziffer 74 einen Magneten, der ein Magnetfeld 75 erzeugt. Der Magnet 74 ist an einem ersten Teil 76 angeordnet, das hier als - insbesondere weitgehend kreisrunde - Trageplatte ausgebildet ist. Ein zweites Teil ist mit der Bezugsziffer 78 bezeichnet. Das zweite Teil 78 ist hier ein Rahmen, der in etwa konzentrisch um das erste Teil 76 herum angeordnet. Mit den Bezugsziffern 80, 82 sind zwei Magnetfeldsensoren bezeichnet, die in einem bevorzugten Ausführungsbeispiel magnetoresistive AMR-Sensoren sind. Die Sensoren 80, 82 sind mit einem Abstand 84 voneinander angeordnet. In dem Abstand zwischen den Sensoren 80, 82 ist der Magnet 74 angeordnet. Jeder Sensor 80, 82 liefert ein Ausgangssignal 86 bzw. 88, das von der Richtung der magnetischen Feldlinien am Ort des jeweiligen Sensors abhängt. In einem Ausführungsbeispiel sind die Sensoren 80, 82 Winkelsensoren, die ein - insbesondere digitales - Ausgangssignal liefern, das für die Magnetfeldrichtung des Magneten 74 am Ort des jeweiligen Sensors repräsentativ ist. Die Ausgangssignale 86, 88 sind einem Schaltkreis 90 zugeführt, der hier einen Addierer 92 beinhaltet. Der Addierer 92 bildet ein Summensignal der beiden Ausgangssignale 86, 88 unter Berücksichtigung von deren jeweiligem Vorzeichen. In einem Fall kann das Summensignal eine Betragssumme sein. In diesen Fällen wird das Summensignal vorteilhaft durch zwei geteilt, um ein gemeinsames Sensorsignal 94 zu erhalten, das den Betragsmittelwert der beiden Ausgangssignale 86, 88 repräsentiert. In anderen Fällen kann das Summensignal vorzeichenrichtig gebildet werden, so dass aufgrund der gegenläufigen Veränderung der Sensorsignale eine Differenzbildung resultiert.

Das Sensorsignal 94 ist repräsentativ für die Position des Magneten 74 und folglich repräsentativ für die Position des ersten Teils relativ zu dem zweiten Teil entlang einer Messachse 96. Wie in Fig. 3 angedeutet ist, verläuft die Messachse 96 quer zu dem Abstandsvektor 84 zwischen den beiden Sensoren 80, 82, wobei der Magnet 74 entlang der Messachse 96 verschoben ist. Wie man anhand der Feldlinien des Magnetfeldes 75 erkennen kann, detektieren die Sensoren 80, 82 bei einer Verschiebung des Magneten 74 entlang der Messachse 96 eine andere Magnetfeldrichtung, was zu einem entsprechend veränderten Sensorsignal 94 führt.

Gemäß Fig. 4 beinhaltet jeder Magnetfeldsensor 80, 82 eine Widerstandsmessbrücke 83a, 83b bzw. 85a, 85b. Jede Widerstandsmessbrücke 83a, 83b, 85a, 85b bildet einen eigenen Magnetfeldsensor, der ein von der Magnetfeldrichtung abhängiges Ausgangssignal 86a, 86b, 88a, 88b erzeugt. Die Ausgangssignale 86a, 88a sind analoge Ausgangsignale mit jeweils einem Momentanwert 89a, der sinusförmig von der Magnetfeldrichtung am Ort der Widerstandsmessbrücke 83a, 85a abhängt. Die Ausgangssignale 86b, 88b sind analoge Ausgangsignale mit jeweils einem Momentanwert 89b, der kosinusförmig von der Magnetfeldrichtung am Ort der Widerstandsmessbrücke 83b, 85b abhängt. Die beiden sinusförmigen Ausgangssignale 86a, 88a sind elektrisch parallel geschaltet. Ebenso sind die beiden kosinusförmigen Ausgangssignale 88a, 88b elektrisch parallel geschaltet.

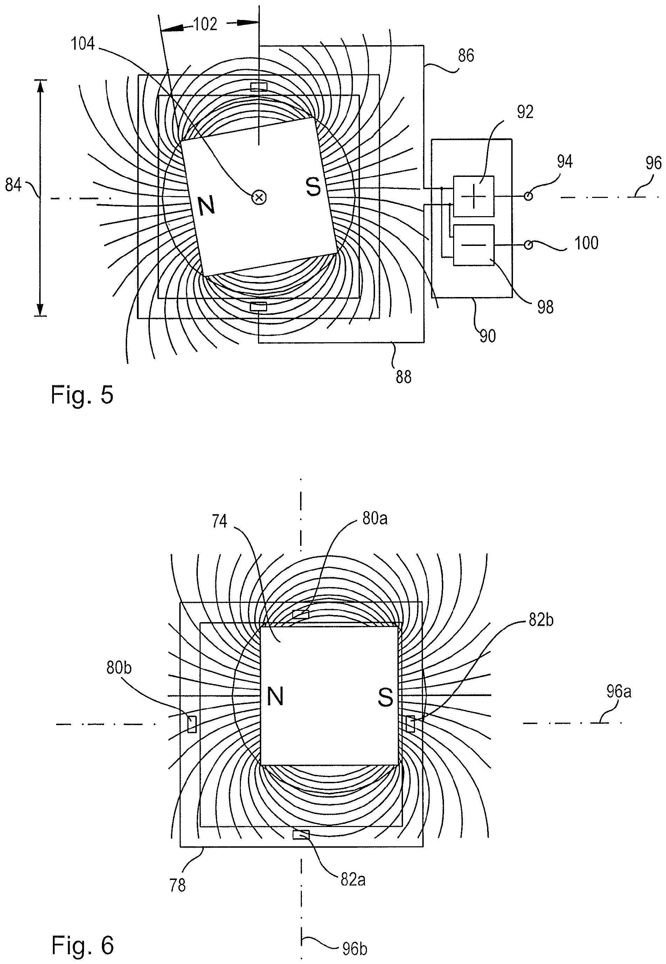

Fig. 5 zeigt einen Fall, in dem der Schaltkreis 90 zusätzlich zu dem Addierer 92 einen Subtrahierer 98 beinhaltet. Der Subtrahierer 98 bildet die Differenz der beiden Ausgangssignale 86, 88 und stellt ein weiteres gemeinsames Sensorsignal 100 bereit, das aufgrund der Differenzbildung eine Verdrehung des ersten Teils relativ zu dem zweiten Teil um einen Drehwinkel 102 repräsentiert. Wie man anhand von Fig. 5 erkennen kann, liegt der Drehwinkel 102 in einer Ebene, die von dem Abstandsvektor 84 und der Messachse 96 aufgespannt wird. Anders ausgedrückt repräsentiert das Sensorsignal 100 eine Drehung des ersten Teils relativ zu dem zweiten Teil um eine Drehachse 104, die senkrecht auf einer Messebene steht, die von den Sensoren 80, 82 aufgespannt wird. In genau dieser Messebene verlaufen auch die Feldlinien des Magnetfeldes 75. In den bevorzugten Ausführungsbeispielen repräsentieren die Sensorsignale 94, 100 also eine jeweils aktuelle Position des ersten Teils relativ zu dem zweiten Teil in Bezug auf zwei Freiheitsgrade, nämlich einen translatorischen Freiheitsgrad entlang der Messachse 96 und einen rotatorischen Freiheitsgrad um die Drehachse 104.

Fig. 6 zeigt eine Weiterbildung der Sensoranordnung aus Fig. 5 mit zwei Sensorpaaren 80a, 82a und 80b, 82b. Das Sensorpaar 80a, 82a entspricht dem Sensorpaar 80, 82 aus den Fig. 3 bis 5. Das weitere Sensorpaar 80b, 82b ist in der Messebene der Sensoren 80a, 82a um 90° verdreht zu dem Sensorpaar 80a, 82a angeordnet. Somit liefert das weitere Sensorpaar 80b, 82b ein gemeinsames Sensorsignal entlang einer weiteren Messachse 96b, die hier orthogonal zu der ersten Messachse 96a liegt.

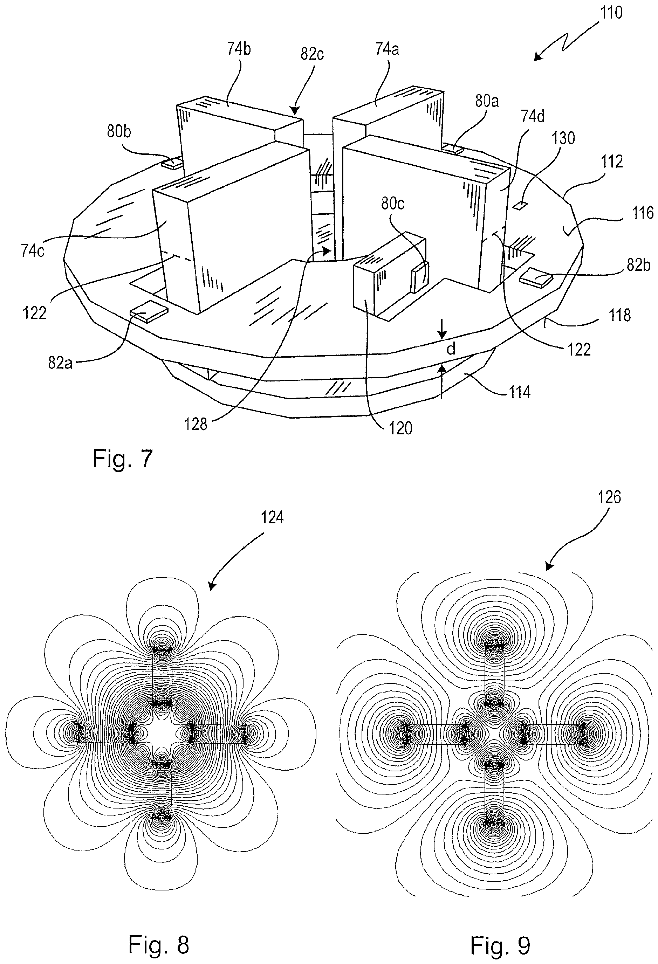

Fig. 7 zeigt ein bevorzugtes Ausführungsbeispiel der Sensoranordnung, die hier in ihrer Gesamtheit mit der Bezugsziffer 110 bezeichnet ist. Die Sensoranordnung 110 beinhaltet einen in etwa kreisscheibenförmigen Bauteilträger 112, der über einem weiteren Träger 114 angeordnet ist. Der Bauteilträger 112 besitzt eine Oberseite 116 und eine Unterseite 118. Auf der Oberseite 116 sind vier Magnetfeldsensoren 80a, 82a, 80b, 82b angeordnet, die eine gemeinsame Messebene auf der Oberseite 116 aufspannen. Die Magnetfeldsensoren 80a, 82a und 80b, 82b liegen jeweils mit einem Abstand 84 (vgl. Fig. 5) zueinander am äußeren Rand des Bauteilträgers 112 und bilden ein Paar von Magnetfeldsensoren.

Zusätzlich besitzt die Sensoranordnung 110 hier ein drittes Sensorpaar, von dem in Fig. 7 allerdings nur ein Magnetfeldsensor 80c sichtbar ist. Ein weiterer Sensor 82c ist auf der in Fig. 7 abgewandten Rückseite der Sensoranordnung 110 angeordnet. Wie man anhand des Magnetfeldsensors 80c erkennen kann, sind die Sensoren 80c, 82c hier senkrecht zu der Messebene der Sensoren 80a, 82a, 80b, 82b an einem Halter 120 angeordnet, wobei der Halter 120 am Bauteilträger 112 befestigt ist. Die magnetisch wirksame Fläche der Sensoren 80c, 82c steht hier weitgehend senkrecht zu der Oberseite 116. Damit sind die Sensoren 80c, 82c optimal ausgerichtet, um eine Bewegung des Bauteilträgers 112 relativ zu dem weiteren Träger 114 in einer Richtung zu erfassen, die senkrecht zu der Oberseite 116 verläuft. In den bevorzugten Ausführungsbeispielen, in denen die Sensoranordnung 110 in einem Tastkopf der in Fig. 2 gezeigten Art verwendet wird, bilden die Sensoren 80c, 82c ein gemeinsames Sensorsignal, das für eine Auslenkung des Taststiftes 22 in z-Richtung repräsentativ ist, während die beiden Sensorpaare 80a, 82a und 80b, 82b jeweils Sensorsignale liefern, die für die Auslenkungen in x- bzw. y-Richtung repräsentativ sind.

Das gemeinsame Magnetfeld der Sensorpaare 80a, 82a, 80b, 82b, 80c, 82c wird bei der Sensoranordnung 110 mit Hilfe von vier Magneten 74a, 74b, 74c, 74d erzeugt, die hier jeweils quaderförmig sind. Jeweils zwei Magnete 74a, 74c bzw. 74b, 74d stehen sich mit ihren Schmalseiten gegenüber. Die Magnete 74a, 74b, 74c, 74d bilden in einer Draufsicht auf die Oberseite 116 ein Kreuz. In bevorzugten Ausführungsbeispielen verläuft die Nord-Süd-Achse 122 jedes Magneten 74 parallel zu der Messebene, die die Sensoren 80a, 82a, 80b, 82b auf die Oberseite 116 des Bauteilträgers 112 aufspannen. Je nachdem, ob sich bei einem Umlauf entlang der Oberfläche 116 jeweils gleiche oder ungleiche Magnetpole gegenüberstehen, ergibt sich ein anderes gemeinsames Magnetfeld.

Fig. 8 zeigt das gemeinsame Magnetfeld 124 der Sensoranordnung 110 in einer Draufsicht auf die Oberseite 116, wenn sich die Nord- und Südpole der Magneten 74 in Umlaufrichtung abwechseln, d.h. wenn sich entlang der Oberfläche 116 jeweils ein Nord- und ein Südpol gegenüberstehen. Fig. 9 zeigt dagegen das gemeinsame Magnetfeld 126 der Sensoranordnung 110, wenn sich bei einem Umlauf entlang der Oberseite 116 gleiche Magnetpole gegenüberstehen. In beiden Fällen resultiert ein gemeinsames Magnetfeld, das um eine fiktive Drehachse, die senkrecht zu der Oberseite 116 steht, rotationssymmetrisch ist. Damit eigenen sich die gemeinsamen Magnetfelder 124, 126 jeweils optimal, um Auslenkungen eines Taststiftes in zwei orthogonalen Raumrichtungen die bestimmen, die vorteilhafterweise beide senkrecht zur Erdanziehungskraft stehen (und somit typischerweise die x- und die y-Achse der Taststiftbewegungen repräsentieren). Beide Magnetfeldvarianten besitzen im Bereich der Magnetfeldsensoren 80a, 80b, 82a, 82b recht stark gekrümmte Linienverläufe, was eine Positionsbestimmung mit hoher Genauigkeit ermöglicht.

Wie man in Fig. 7 erkennen kann, besitzt der Bauteilträger 112 eine zentrale, weitgehend kreuzförmige Ausnehmung 128, in der die kreuzförmig angeordneten Magnete 74a, 74b, 74c, 74d angeordnet sind. Die Magnete sind an dem weiteren Träger 114 befestigt und mit diesem als Gesamtheit relativ zu dem Bauteilträger 112 bewegbar. In Ausführungsbeispielen kann der weitere Träger 114 mit dem Magneten 74 an dem Stab 68 (vgl. Fig. 2) befestigt sein, während der Bauteilträger 116 mit der Tastkopfbasis 52 gekoppelt ist. Bei einer Auslenkung des Taststiftes 22 relativ zur Tastkopfbasis verändert sich die Position des gemeinsamen Magnetfeldes 124 oder 126 relativ zu den Sensorpaaren. Die jeweils aktuelle Position des Magnetfeldes und damit die aktuelle Position des Taststiftes 22 kann mit Hilfe der Sensorpaare in den drei Raumrichtungen bestimmt werden.

In einer Variante des in Fig. 7 gezeigten Ausführungsbeispiels ist der Bauteilträger 112 sowohl auf der Oberseite 116 als auch auf der Unterseite 118 mit Sensorpaaren 80a, 82a und 80b, 82b bestückt (hier nicht sichtbar). In dieser Variante ist die Dicke d des Bauteilträgers 112 so groß gewählt, dass die Sensorpaare auf der Oberseite 116 und die Sensorpaare auf der Unterseite 118 zwei zueinander parallele, jedoch um den Abstand d voneinander entfernte Messebenen bilden, wobei der Abstand d groß genug ist, um anhand der Sensorsignale aus den parallelen Messebenen eine Verkippung des Bauteilträgers 112 um die x- und y-Achse zu bestimmen. Dabei verläuft die x- und y-Achse parallel zu den beiden Messebenen. Eine Verdrehung des Bauteilträgers 112 um die z-Achse wird vorteilhaft mit Hilfe eines Subtrahierers 98 gemäß Fig. 5 bestimmt.

In allen bevorzugten Ausführungsbeispielen besteht der Bauteilträger 112 aus einem thermisch stabilen Material, d.h. einem Material mit einem geringen Temperaturausdehnungskoeffizienten. In einigen Ausführungsbeispielen ist auf dem Bauteilträger 112 ein Temperatursensor 130 angeordnet. Mit Hilfe des Temperatursensors 130 kann die Auswerte- und Steuereinheit 34 des Koordinatenmessgerätes 10 oder eine Signalverarbeitungseinheit in der Sensoranordnung 110 eine Temperaturkompensation durchführen, indem thermisch bedingte Positionsänderungen des Bauteilträgers 112 relativ zu dem Magnetfeld 124, 126 anhand des bekannten Temperaturkoeffizienten korrigiert werden.

In anderen Ausführungsbeispielen kann die Sensoranordnung 110 ohne Temperatursensor 126 realisiert sein, indem die gemeinsamen Sensorsignale 94 der Sensorpaare bei einer Referenztemperatur bestimmt und als Referenzwerte in einem Speicher der Auswerteeinheit bereitgestellt werden. Vor Durchführung einer aktuellen Messung bestimmt die Auswerteeinheit zunächst die gemeinsamen Sensorsignale der Sensorpaare, während sich der Bauteilträger 112 in seiner Ruheposition befindet. Aus der Differenz der aktuell ermittelten Sensorsignale und der Sensorsignale bei Referenztemperatur werden Korrekturwerte für eine Temperaturkompensation bestimmt. In einigen Ausführungsbeispielen findet diese Temperaturkompensation in der Auswerte- und Steuereinheit 34 des Koordinatenmessgerätes 10 statt. Die Auswerteeinheit 34 beinhaltet folglich eine Temperaturkorrekturstufe. In anderen Ausführungsbeispielen kann die Temperaturkorrekturstufe auf dem Bauteilträger 112 integriert sein.

## Patentansprüche

1. Sensoranordnung zum Bestimmen einer räumlichen Position eines ersten Teils (76; 114) relativ zu einem zweiten Teil (78; 112), mit zumindest einem Magneten (74), der an dem ersten Teil (76; 114) angeordnet ist und ein Magnetfeld (75; 124; 126) erzeugt, das sich bis zu dem zweiten Teil (78; 112) erstreckt, und mit zumindest vier Magnetfeldsensoren (80a, 80b, 82a, 82b), die ein erstes Paar (80a, 82a) und ein zweites Paar (80b, 82b) mit jeweils einem ersten Magnetfeldsensor (80a, 80b) und jeweils einem zweiten Magnetfeldsensor (82a, 82b) bilden, wobei der erste Magnetfeldsensor (80a, 80b) und der zweite Magnetfeldsensor (82a, 82b) jeweils mit einem räumlichen Abstand (84) zueinander an dem zweiten Teil (76; 114) angeordnet sind und in Abhängigkeit von dem Magnetfeld (75; 124; 126) jeweils ein Ausgangssignal (86, 88) erzeugen, wobei der zumindest eine Magnet (74) in dem jeweiligen räumlichen Abstand (84) positioniert ist, und wobei die Ausgangssignale (86, 88) des jeweiligen ersten Magnetfeldsensors (80a, 80b) und des jeweiligen zweiten Magnetfeldsensors (82a, 82b) jeweils zu einem gemeinsamen Sensorsignal (94, 100) kombiniert sind, das von der räumlichen Position des ersten Teils (76; 114) relativ zu dem zweiten Teil (78; 112) entlang einer definierten Messachse (96) abhängt, wobei die definierte Messachse (96) quer zu dem jeweiligen räumlichen Abstand (84) liegt, wobei die Ausgangssignale (86, 88) der ersten und zweiten Magnetfeldsensoren (80a, 80b, 82a, 82b) im Wesentlichen eine Magnetfeldrichtung am Ort des jeweiligen Magnetfeldsensors (80a, 80b, 82a, 82b) repräsentieren, und wobei jedes Paar das jeweilige gemeinsame Sensorsignal (94, 100) in Bezug auf eine von zumindest zwei zueinander orthogonalen Messachsen (96a, 96b) erzeugt.

2. Sensoranordnung nach Anspruch 1, **gekennzeichnet durch** einen Addierer (92), der die Ausgangssignale (86, 88) des jeweiligen ersten und zweiten Magnetfeldsensors (80a, 80b, 82a, 82b) addiert, um das gemeinsame Sensorsignal (94) zu bestimmen.

3. Sensoranordnung nach Anspruch 1 oder 2, **gekennzeichnet durch** einen Subtrahierer (98), der eine Differenz zwischen den Ausgangssignalen (86, 88) des jeweiligen ersten und zweiten Magnetfeldsensors (80a, 80b, 82a, 82b) bildet, um das gemeinsame Sensorsignal (100) zu bestimmen.

4. Sensoranordnung nach einem der Ansprüche 1 bis 3, **dadurch gekennzeichnet, dass** die Magnetfeldsensoren (80a, 80b, 82a, 82b) jeweils einen elektrischen Widerstand besitzen, der sich in Abhängigkeit von der Magnetfeldrichtung verändert.

5. Sensoranordnung nach einem der Ansprüche 1 bis 4, **dadurch gekennzeichnet, dass** der erste und der zweite Magnetfeldsensor (80a, 80b, 82a, 82b) jeweils zwei verschiedene analoge Ausgangssignale (86a, 86b, 88a, 88b) mit jeweils einem Momentanwert erzeugen, der sinus- oder cosinusförmig von der Magnetfeldrichtung am Ort des jeweiligen Magnetfeldsensors (80, 82) abhängt.

6. Sensoranordnung nach einem der Ansprüche 1 bis 5, **gekennzeichnet durch** einen Bauteilträger (112), an dem die Magnetfeldsensoren (80a, 80b, 82a, 82b) der Paare gemeinsam angeordnet sind.

7. Sensoranordnung nach Anspruch 6, **dadurch gekennzeichnet, dass** der Bauteilträger (112) eine zentrale Ausnehmung (124) aufweist, in der der zumindest eine Magnet (74) angeordnet ist.

8. Sensoranordnung nach Anspruch 7, **gekennzeichnet durch** eine Vielzahl von Magneten (74a, 74b, 74c, 74d), die in der Ausnehmung (124) angeordnet sind und ein gemeinsames Magnetfeld (124; 126) erzeugen.

9. Sensoranordnung nach einem der Ansprüche 6 bis 8, **dadurch gekennzeichnet, dass** der Bauteilträger (112) eine Oberseite (116) und eine Unterseite (118) aufweist, an denen jeweils erste und zweite Magnetfeldsensoren (80a, 80b, 82a, 82b) angeordnet sind.

10. Sensoranordnung nach einem der Ansprüche 1 bis 9, **gekennzeichnet durch** eine Temperaturkorrekturstufe (34), die dazu ausgebildet ist, eine thermisch bedingte Positionsänderung von dem ersten Teil (76; 114) relativ zu dem zweiten Teil (78; 112) anhand der Ausgangssignale (86, 88) zu bestimmen.

11. Tastkopf für ein Koordinatenmessgerät, mit einer Tastkopfbasis (52) und einem Tastelement (22), das an der Tastkopfbasis (52) beweglich gelagert ist, und mit einer Sensoranordnung (110) nach einem der Ansprüche 1 bis 10 zum Bestimmen einer aktuellen Position des Tastelements (22) relativ zur Tastkopfbasis (52).

12. Verfahren zum Bestimmen einer räumlichen Position eines ersten Teils (76; 114) relativ zu einem zweiten Teil (78; 112), mit den Schritten:
- Anordnen von zumindest einem Magneten (74) an dem ersten Teil (76; 114), so dass der Magnet (74) ein Magnetfeld (75; 124; 126) erzeugt, das sich bis zu dem zweiten Teil (78; 112) erstreckt,
- Anordnen von zumindest vier Magnetfeldsensoren (80a, 80b, 82a, 82b), die ein erstes Paar (80a, 82a) und ein zweites Paar (80b, 82b) mit jeweils einem ersten Magnetfeldsensor (80a, 80b) und jeweils einem zweiten Magnetfeldsensor (82a, 82b) bilden, mit jeweils räumlichem Abstand (84) zueinander an dem zweiten Teil (78; 112), wobei der zumindest eine Magnet (74) in dem jeweiligen räumlichen Abstand (84) zwischen dem jeweiligen ersten Magnetfeldsensor (80a, 80b) und dem jeweiligen zweiten Magnetfeldsensor (82a, 82b) positioniert wird,
- Aufnehmen eines jeweiligen ersten Ausgangssignals (86) von dem jeweiligen ersten Magnetfeldsensor (80a, 80b) und Aufnehmen eines jeweiligen zweiten Ausgangssignals (88) von dem jeweiligen zweiten Magnetfeldsensor (82a, 82b), wobei das erste und das zweite Ausgangsignal (86, 88) jeweils von einer Sensorposition des jeweiligen Magnetfeldsensors (80a, 80b, 82a, 82b) im Magnetfeld (75; 124; 126) abhängen, und
- Bestimmen eines jeweiligen gemeinsamen Sensorsignals (94), das von der räumlichen Position des ersten Teils (76; 114) relativ zu dem zweiten Teil (78; 112) entlang einer jeweils definierten Messachse (96) abhängt, indem die Ausgangssignale (86, 88) des jeweiligen ersten Magnetfeldsensor (80a, 80b) und des jeweiligen zweiten Magnetfeldsensors (82a, 82b) zu jeweils einem gemeinsamen Sensorsignal (94) kombiniert werden,
wobei die jeweils definierte Messachse (96) quer zu dem jeweiligen räumlichen Abstand (84) gewählt wird, wobei die Ausgangssignale (86, 88) des jeweiligen ersten Magnetfeldsensors (80a, 80b) und des jeweiligen zweiten Magnetfeldsensors (82a, 82b) im Wesentlichen eine Magnetfeldrichtung am Ort des jeweiligen Magnetfeldsensors (80a, 80b, 82a, 82b) repräsentieren, und wobei jedes Paar das jeweilige gemeinsame Sensorsignal (94, 100) in Bezug auf eine von zumindest zwei zueinander orthogonalen Messachsen (96a, 96b) erzeugt.

## Claims

1. Sensor assembly for the determination of a spatial position of a first part (76; 114) relative to a second part (78; 112), having at least one magnet (74) that is disposed on the first part (76; 114) and that generates a magnetic field (75; 124; 126) that extends to the second part (78; 112), and having at least four magnetic field sensors (80a, 80b, 82a, 82b) which form a first pair (80a, 82a) and a second pair (80b, 82b) each with a first magnetic field sensor (80a, 80b) and a second magnetic field sensor (82a, 82b), wherein the first magnetic field sensor (80a, 80b) and the second magnetic field sensor (82a, 82b) are each disposed at a spatial distance (84) from each other on the second part (76; 114) and each generate an output signal (86, 88) depending on the magnetic field (75; 124; 126), wherein the at least one magnet (74) is positioned in the respective spatial distance (84), and wherein the output signals (86, 88) of the respective first magnetic field sensor (80a, 80b) and of the respective second magnetic field sensor (82a, 82b) are each combined to form a common sensor signal (94, 100) which depends on the spatial position of the first part (76; 114) relative to the second part (78; 112) along a defined measurement axis (96), wherein the defined measurement axis (96) lies transversely to the respective spatial distance (84), wherein the output signals (86, 88) of the first and second magnetic field sensors (80a, 80b, 82a, 82b) essentially represent a magnetic field direction at the location of the respective magnetic field sensor (80a, 80b, 82a, 82b), and wherein each pair generates the respective common sensor signal (94, 100) with respect to one of at least two measurement axes (96a, 96b) which are orthogonal to one another.

2. Sensor assembly according to Claim 1, **characterized by** an adder (92) which adds the output signals (86, 88) of the respective first and second magnetic field sensors (80a, 80b, 82a, 82b) in order to determine the common sensor signal (94).

3. Sensor assembly according to Claim 1 or 2, **characterized by** a subtractor (98) which forms a difference between the output signals (86, 88) of the respective first and second magnetic field sensors (80a, 80b, 82a, 82b) in order to determine the common sensor signal (100).

4. Sensor assembly according to one of the Claims 1 to 3, **characterized in that** the magnetic field sensors (80a, 80b, 82a, 82b) each have an electrical resistance which varies depending on the magnetic field direction.

5. Sensor assembly according to one of the Claims 1 to 4, **characterized in that** the first and second magnetic field sensors (80a, 80b, 82a, 82b) each generate two different analogue output signals (86a, 86b, 88a, 88b), each with an instantaneous value that depends sinusoidally or cosinusoidally on the magnetic field direction at the location of the respective magnetic field sensor (80, 82).

6. Sensor assembly according to one of the Claims 1 to 5, **characterized by** a component support (112), on which the magnetic field sensors (80a, 80b, 82a, 82b) of the pairs are jointly disposed.

7. Sensor assembly according to Claim 6, **characterized in that** the component support (112) has a central recess (124) in which the at least one magnet (74) is disposed.

8. Sensor assembly according to Claim 7, **characterized by** a plurality of magnets (74a, 74b, 74c, 74d) which are disposed in the recess (124) and generate a common magnetic field (124; 126).

9. Sensor assembly according to one of Claims 6 to 8, **characterized in that** the component support (112) has an upper side (116) and an underside (118), on each of which first and second magnetic field sensors (80a, 80b, 82a, 82b) are disposed.

10. Sensor assembly according to one of Claims 1 to 9, **characterized by** a temperature correction stage (34) that is designed to determine a thermally induced position change of the first part (76; 114) relative to the second part (78; 112) from the output signals (86, 88).

11. Sensing head for a coordinate measuring machine, having a sensing head base (52) and a sensing element (22) which is movably mounted on the sensing head base (52), and having a sensor assembly (110) according to one of Claims 1 to 10 for the determination of a current position of the sensing element (22) relative to the sensing head base (52).

12. Method for the determination of a spatial position of a first part (76; 114) relative to a second part (78; 112), having the steps:
- arranging at least one magnet (74) on the first part (76; 114) so that the magnet (74) generates a magnetic field (75; 124; 126) that extends to the second part (78; 112),
- arranging at least four magnetic field sensors (80a, 80b, 82a, 82b), which form a first pair (80a, 82a) and a second pair (80b, 82b) each with a first magnetic field sensor (80a, 80b) and each a second magnetic field sensor (82a, 82b), at a respective spatial distance (84) from each other on the second part (78; 112), wherein the at least one magnet (74) is positioned in the respective spatial distance (84) between the respective first magnetic field sensor (80a, 80b) and the respective second magnetic field sensor (82a, 82b),
- receiving a respective first output signal (86) from the respective first magnetic field sensor (80a, 80b) and receiving a respective second output signal (88) from the respective second magnetic field sensor (82a, 82b), wherein the first and second output signals (86, 88) each depend on a sensor position of the respective magnetic field sensor (80a, 80b, 82a, 82b) in the magnetic field (75; 124; 126), and
- determining a respective common sensor signal (94) which depends on the spatial position of the first part (76; 114) relative to the second part (78; 112) along a respectively defined measurement axis (96) by combining the output signals (86, 88) of the respective first magnetic field sensor (80a, 80b) and the respective second magnetic field sensor (82a, 82b) to form a respective common sensor signal (94),
wherein the respectively defined measurement axis (96) is selected to be transverse to the respective spatial distance (84), wherein the output signals (86, 88) of the respective first magnetic field sensor (80a, 80b) and the respective second magnetic field sensor (82a, 82b) essentially represent a magnetic field direction at the location of the respective magnetic field sensor (80a, 80b, 82a, 82b), and wherein each pair generates the respective common sensor signal (94, 100) with respect to one of at least two measurement axes (96a, 96b) which are orthogonal to one another.

## Revendications

1. Ensemble capteur pour déterminer une position spatiale d'une première pièce (76 ; 114) par rapport à une deuxième pièce (78 ; 112), comprenant au moins un aimant (74) disposé sur la première pièce (76 ; 114) et générant un champ magnétique (75 ; 124 ; 126) qui s'étend jusqu'à la deuxième pièce (78 ; 112), et au moins quatre capteurs de champ magnétique (80a, 80b, 82a, 82b) constituant une première paire (80a, 82a) et une deuxième paire (80b, 82b) avec respectivement un premier capteur de champ magnétique (80a, 80b) et respectivement un deuxième capteur de champ magnétique (82a, 82b), dans lequel le premier capteur de champ magnétique (80a, 80b) et le deuxième capteur de champ magnétique (82a, 82b) sont disposés respectivement à une distance spatiale (84) l'un de l'autre sur la deuxième pièce (76 ; 114) et génèrent respectivement un signal de sortie (86, 88) en fonction du champ magnétique (75 ; 124 ; 126), ledit au moins un aimant (74) étant positionné à la distance spatiale respective (84), et dans lequel les signaux de sortie (86, 88) du premier capteur de champ magnétique respectif (80a, 80b) et du deuxième capteur de champ magnétique respectif (82a, 82b) sont combinés respectivement en un signal de capteur commun (94, 100) qui dépend de la position spatiale de la première pièce (76 ; 114) par rapport à la deuxième pièce (78 ; 112) le long d'un axe de mesure défini (96), l'axe de mesure défini (96) étant situé transversalement à la distance spatiale respective (84), dans lequel les signaux de sortie (86, 88) des premier et deuxième capteurs de champ magnétique (80a, 80b, 82a, 82b) représentent substantiellement une direction de champ magnétique à l'endroit du capteur de champ magnétique respectif (80a, 80b, 82a, 82b), et dans lequel chaque paire génère le signal de capteur commun respectif (94, 100) par rapport à l'un parmi au moins deux axes de mesure (96a, 96b) orthogonaux l'un par rapport à l'autre.

2. Ensemble capteur selon la revendication 1, **caractérisé par** un additionneur (92) qui additionne les signaux de sortie (86, 88) des premier et deuxième capteurs de champ magnétique respectifs (80a, 80b, 82a, 82b) afin de déterminer le signal de capteur commun (94) .

3. Ensemble capteur selon la revendication 1 ou 2, **caractérisé par** un soustracteur (98) établissant une différence entre les signaux de sortie (86, 88) des premier et deuxième capteurs de champ magnétique respectifs (80a, 80b, 82a, 82b) afin de déterminer le signal de capteur commun (100).

4. Ensemble capteur selon l'une quelconque des revendications 1 à 3, **caractérisé en ce que** les capteurs de champ magnétique (80a, 80b, 82a, 82b) possèdent respectivement une résistance électrique qui change en fonction de la direction de champ magnétique.

5. Ensemble capteur selon l'une quelconque des revendications 1 à 4, **caractérisé en ce que** les premier et deuxième capteurs de champ magnétique (80a, 80b, 82a, 82b) génèrent respectivement deux signaux de sortie analogiques différents (86a, 86b, 88a, 88b) avec respectivement une valeur instantanée dépendant de manière sinusoïdale ou cosinusoïdale de la direction de champ magnétique à l'endroit du capteur de champ magnétique respectif (80, 82).

6. Ensemble capteur selon l'une quelconque des revendications 1 à 5, **caractérisé par** un support de composants (112) sur lequel les capteurs de champ magnétique (80a, 80b, 82a, 82b) des paires sont disposés ensemble.

7. Ensemble capteur selon la revendication 6, **caractérisé en ce que** le support de composants (112) présente un creux central (124) dans lequel est disposé ledit au moins un aimant (74).

8. Ensemble capteur selon la revendication 7, **caractérisé par** une pluralité d'aimants (74a, 74b, 74c, 74d) disposés dans le creux (124) et générant un champ magnétique commun (124 ; 126).

9. Ensemble capteur selon l'une quelconque des revendications 6 à 8, **caractérisé en ce que** le support de composants (112) présente une face supérieure (116) et une face inférieure (118) sur lesquelles sont disposés respectivement des premier et deuxième capteurs de champ magnétique (80a, 80b, 82a, 82b).

10. Ensemble capteur selon l'une quelconque des revendications 1 à 9, **caractérisé par** un étage de correction de température (34) réalisé pour déterminer un changement de position d'origine thermique de la première pièce (76 ; 114) par rapport à la deuxième pièce (78 ; 112) à l'aide des signaux de sortie (86, 88) .

11. Sonde pour un appareil de mesure de coordonnées, comprenant une base de sonde (52) et un élément palpeur (22) monté mobile sur la base de sonde (52), et un ensemble capteur (110) selon l'une quelconque des revendications 1 à 10 pour déterminer une position actuelle de l'élément palpeur (22) par rapport à la base de sonde (52).

12. Procédé pour déterminer une position spatiale d'une première pièce (76 ; 114) par rapport à une deuxième pièce (78 ; 112), comprenant les étapes consistant à :
- disposer au moins un aimant (74) sur la première pièce (76 ; 114) de sorte que l'aimant (74) génère un champ magnétique (75 ; 124 ; 126) s'étendant jusqu'à la deuxième pièce (78 ; 112),
- disposer au moins quatre capteurs de champ magnétique (80a, 80b, 82a, 82b) constituant une première paire (80a, 82a) et une deuxième paire (80b, 82b) avec respectivement un premier capteur de champ magnétique (80a, 80b) et respectivement un deuxième capteur de champ magnétique (82a, 82b), respectivement à une distance spatiale (84) l'un de l'autre sur la deuxième pièce (78 ; 112), ledit au moins un aimant (74) étant positionné à la distance spatiale respective (84) entre le premier capteur de champ magnétique respectif (80a, 80b) et le deuxième capteur de champ magnétique respectif (82a, 82b),
- capter un premier signal de sortie respectif (86) du premier capteur de champ magnétique respectif (80a, 80b) et capter un deuxième signal de sortie respectif (88) du deuxième capteur de champ magnétique respectif (82a, 82b), les premier et deuxième signaux de sortie (86, 88) dépendant respectivement d'une position de capteur du capteur de champ magnétique respectif (80a, 80b, 82a, 82b) dans le champ magnétique (75 ; 124 ; 126), et
- déterminer un signal de capteur commun respectif (94) dépendant de la position spatiale de la première pièce (76 ; 114) par rapport à la deuxième pièce (78 ; 112) le long d'un axe de mesure respectivement défini (96) en ce que les signaux de sortie (86, 88) du premier capteur de champ magnétique respectif (80a, 80b) et du deuxième capteur de champ magnétique respectif (82a, 82b) sont combinés en un signal de capteur commun (94) respectivement,
dans lequel l'axe de mesure défini (96) respectivement est choisi transversalement à la distance spatiale respective (84), les signaux de sortie (86, 88) du premier capteur de champ magnétique respectif (80a, 80b) et du deuxième capteur de champ magnétique respectif (82a, 82b) représentant substantiellement une direction de champ magnétique à l'endroit du capteur de champ magnétique respectif (80a, 80b, 82a, 82b), et chaque paire générant le signal de capteur commun respectif (94, 100) par rapport à l'un parmi au moins deux axes de mesure (96a, 96b) orthogonaux l'un par rapport à l'autre.
